# EUROPEAN PATENT SPECIFICATION

(11) **EP 1 394 944 B1**
(45) Date of publication and mention of the grant of the patent: **22.10.2008**
(21) Application number: 03102654.5
(22) Date of filing: 26.08.2003
(51) Int. Cl.: H03K 3/356

(54) **Differential CMOS latch and digital quadrature LO generator using same**
Differential-CMOS-Kippschaltung in einem Lokalquadraturoszillator
Bascule CMOS différentiel dans un oscillateur en quadrature local

(30) Priority: 26.08.2002 US 227937
(43) Date of publication of application: 03.03.2004
(73) Proprietor: Texas Instruments Incorporated, Dallas, Texas 75251 (US)
(72) Inventor: Fang, Sher J., 98115, Seattle (US); Lee, See T., 98115, Seattle (US); Bellaouar, Abdellatif, 75243, Dallas (US)
(74) Representative: Holt, Michael

(56) References cited:
- DE-A- 3 919 053
- US-A- 6 043 696
- PATENT ABSTRACTS OF JAPAN vol. 1995, no. 02, 31 March 1995 (1995-03-31) & JP 06 326564 A (MITSUBISHI ELECTRIC CORP), 25 November 1994 (1994-11-25)

## Description

### FIELD OF THE INVENTION

This invention relates in general to the field of electronic circuits, and more specifically to a differential Complementary Metal Oxide Semiconductor (CMOS) latch and a digital quadrature generator using the CMOS latch.

### BACKGROUND OF THE INVENTION

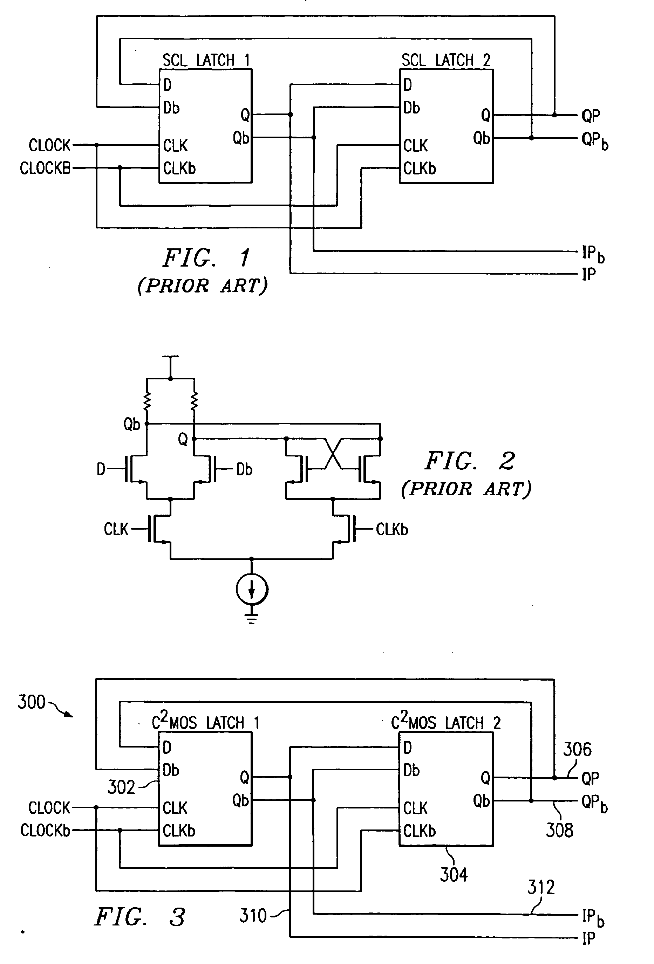

Quadrature Local Oscillator (LO) signal generators are important building blocks in digital wireless communication systems. They are used for example in, quadrature modulators, demodulators and image rejection mixers. A conventional quadrature LO generator is shown in FIG. 1. Several techniques for generating IP (In-phase) and QP (Quadrature-phase) LO signals exist, with the most commonly used technique for generating a pair of quadrature LO signals requiring the use of divide-by 2 circuits. An example of a conventional Source Coupled Logic (SCL) latch is shown in FIG. 2. German Patent Application No. 3919053 describes a differential clocked CMOS latch comprising first and second clock input ports for receiving complementary clock signals, first and second input ports, first and second output ports and a pair of back-to-back inverters coupled between the first and second output ports.

Conventional quadrature Local Oscillator LO signal generators use SCL latches for generating the In-Phase and Quadrature-Phase LO signals. Such LO signal generators have low operating frequency limits, and they do not provide rail-to-rail (i.e., square wave) output signals, which are recommended, for RF CMOS mixers and other circuits. LO generators incorporating SCL latches also suffer from high noise and also consume a large amount of power. SCL latches also need to be followed by a source follower or driver before the signal is sent to the next stage, thereby increasing power consumption. A need thus exists in the art for a new latch and digital quadrature LO generator using this new latch which can provide power consumption improvements and avoid the low-frequency limits of prior art quadrature signal generators.

### BRIEF DESCRIPTION OF THE DRAWINGS

The features of the present invention, which are believed to be novel, are set forth with particularity in the appended claims. The invention, may best be understood by reference to the following description, taken in conjunction with the accompanying drawings, in the several figures of which like reference numerals identify like elements, and in which:
FIG. 1 shows a block diagram of a prior art Quadrature LO generator using SCL latches.
FIG. 2 shows a schematic of a prior art SCL latch.
FIG. 3 shows a block diagram of a digital quadrature LO generator using CMOS latches in accordance with one embodiment of the present invention.
FIG. 4 shows a schematic of a Clocked CMOS latch in accordance with the invention.
FIG. 5 shows an output waveform for the digital quadrature LO generator of FIG. 3.
FIG. 6 is a detailed schematic of the back-to-back inverter section found in FIG. 4.

### DETAILED DESCRIPTION OF THE PREFERRED EMBODIMENTS

While the specification concludes with claims defining the features of the invention that are regarded as novel, it is believed that the invention will be better understood from a consideration of the following description in conjunction with the drawing figures.

Referring now to FIG. 3, there is shown a digital quadrature LO generator 300 in accordance with the preferred embodiment of the invention. Generator 300 includes two Clocked CMOS (also referred herein as C²MOS) latches 302 and 304, which are triggered by the positive and negative edges of an input clock. A clock signal input port (CLK) and a complementary clock signal input port (CLKb, referring to CLK bar) are provided as part of each latch 302 and 304. When the clock signal (CLOCK) presented to the CLK input port is a logic high, the clock signal (CLOCKb) presented to the CLKb port is a logic low and vice-versa. Since the quadrature generator 300 is a divide-by-2 circuit, the input frequency is twice the output frequency. Each latch 302 and 304 includes a pair of differential input ports D and Db and a pair of differential output ports Q and Qb. The latches 302 and 304 are connected together as shown in FIG. 3 in order to provide In-phase (IP 310 and IPb 312) and Quadrature-phase (QP 306 and QPb 308) output signals.

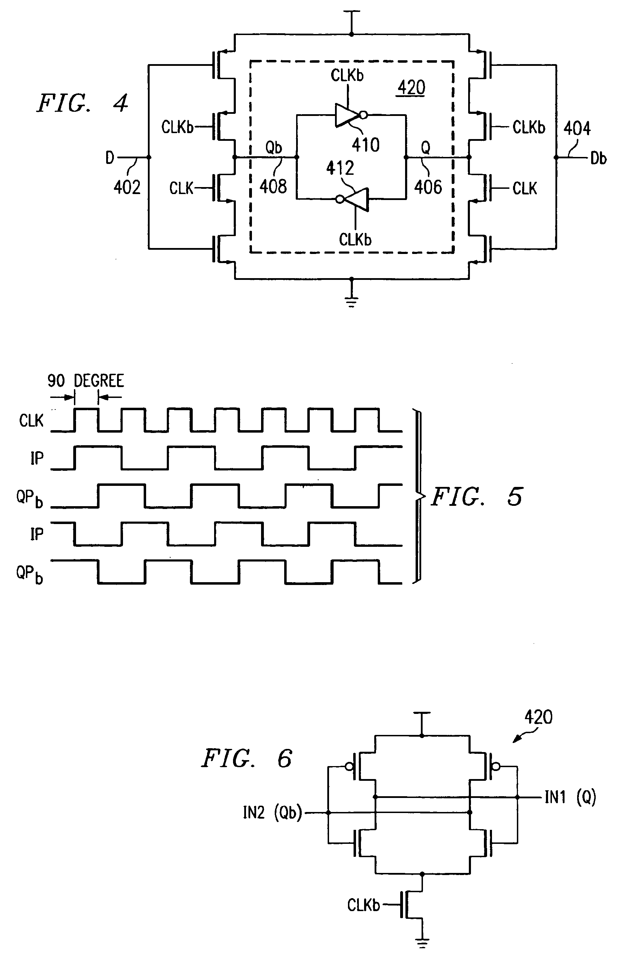

In FIG. 4 there is shown a differential C²MOS latch 400 that can be used for latches 302 and 304 of LO generator 300 in accordance with the invention. This positive level sensitive latch passes the signals present at the D 402 and Db 404 input ports to the Q 406 and Qb 408 output ports when the clock signal (CLOCK) presented to the CLK clock input port is a logic high. When the CLOCK signal is a logic low, the input data is sampled on the falling edge of the CLOCK signal, and is held stable at the LO gnerator's output ports (QP 306, QPb 308) for the entire phase due to the back-to-back inverter 410, 412 connections found in each latch 302,304. The back-to-back inverter section 420 is shown in schematic detail in Fig. 6.

When two of these latches 300 are connected in a master-slave configuration as done in the LO generator 300, one latch 302 acts as a positive latch and the other latch 304 acts as a negative latch. With the negative output (Qb) of the second latch 304 feedback to the positive input (D) of the first latch 302, it will generate In-Phase and Quadrature-Phase signals at half the frequency of the input clock signal. The output waveforms for digital quadrature LO generator 300 is shown in FIG. 5. Note that the performance of generator 300 is power supply dependent.

A simulation at 2 GHz input frequency and using a 1.5 volt power supply, yielded a power consumption of 259 µA for quadrature LO generator 300. The phase noise at different relative offset frequencies is tabulated in Table 1 below.
Quadrature LO generator 300 has the advantage of having no low frequency limit.

**TABLE 1**

| Offset Frequency | Phase Noise |
|---|---|
| 5 MHz | -150.25 dBc/Hz |
| 10 MHz | -151.86 dBc/Hz |
| 20 MHz | -153.0 dBc/Hz |

While the preferred embodiments of the invention have been illustrated and described, it will be clear that the invention is not so limited. Numerous modifications, changes, variations, substitutions and equivalents will occur to those skilled in the art without departing from the scope of the present invention as defined by the appended claims.

## Claims

1. A differential Clocked-CMOS (C²MOS) latch (400), comprising:
first (CLK) (402) and second (CLKb) (404) clock input ports for receiving complementary clock signals (CLOCK and CLOCKb);
first and second input ports (D and Db) (402, 404);
first and second output ports (Q and Qb) (406, 408); and
a pair of back-to-back inverters (420) coupled between the first and second output ports (406, 408);
wherein any signals present at the first and second input ports (402. 404) are sampled in response to the first (CLK) complementary clock input port receiving a falling edge clock signal and any signals present at the first and second input ports (402, 404) are held stable at the first and second output ports (406, 408) in response to the first (CLK) complementary clock input port receiving a logic low level clock signal.

2. A differential C²MOS latch as defined in claim 1, wherein the differential C²MOS latch is a positive level latch that passes signals present at the first and second input ports (402, 404) to the first and second output ports (406, 408) in response to the first (CLK) complementary clock input port receiving a logic high level clock signal.

3. A differential C²MOS latch as defined in any one of claims 1 to 3, further comprising:
a voltage source input port;
a ground port;
first, second, third and fourth transistors coupled together and connected between the voltage source input port and the ground port;
the first and fourth transistors being connected to the first differential output port (D); the second transistor being connected to the second clock input port (CLKb); and the third transistor being connected to the first clock input port (CLK).

4. A differential C²MOS latch as defined in claim 4, wherein the second and third transistors are directly connected to the second output port (Qb) (408).

5. A differential C²MOS latch as defined in claim 5, further comprising:
fifth, sixth, seventh and eighth coupled between the voltage source input port and the ground port.

6. A differential C²MOS latch as defined in claim 5, wherein:
the fifth and eighth transistors are connected to the second differential output port (Db);
the sixth transistor is connected to the second clock input port (CLKb); and
the seventh transistor connected to the first clock input port (CLK).

7. A differential C²MOS latch as defined in claim 6, wherein the sixth and seventh transistors are directly connected to the first output port (Q)

8. A quadrature Local Oscillator (LO) generator (300), comprising:
first and second differential C²MOS latches (302, 304) according to any of claims 1 to 7.

9. A quadrature LO generator (300) of claim 8, wherein
the first and second differential C²MOS latches (302, 304) are coupled together in order to provide a pair of In-phase (IP and IPb) (310, 312) and pair of Quadrature-phase (QP and QPb) output ports (306, 308).

10. A quadrature LO generator (300) as defined in claim 8 or 9, wherein the first and second C²MOS latches (302, 304) are coupled together in a master-slave relationship.

11. A quadrature LO generator as defined in claim 9 or 10, wherein the first C²MOS latch (302) acts as a positive latch and the second C²MOS latch (304) acts as a negative latch.

12. A quadrature LO generator as defined in claim 8, wherein the first output port (406) (Q) of the first latch (302) is coupled to the first input port (D) (402) of the second C²MOS latch (304) and the second output port (Qb) (408) of the first latch (302) is coupled to the second input port (Db) (404) of the second latch (304); and the first and second output ports (406, 408) of the first C²MOS latch (302) provide the In-phase output ports (IP, IPb) (310, 312) for the quadrature LO generator (300), while the first and second output ports (406, 408) of the second C²MOS latch (304) provide the quadrature-phase output ports (QP, QPb) (306, 308) for the quadrature LO generator (300).

## Patentansprüche

1. Differentieller getakteter CMOS-Signalspeicher (C²MOS-Signalspeicher) (400), mit:
einem ersten (CLK) (402) und einem zweiten (CLKb) (404) Takteingangsanschluss zum Empfangen komplementärer Taktsignale (CLOCK und CLOCKb);
einem ersten und einem zweiten Eingangsanschluss (D und Db) (402, 404);
einem ersten und einem zweiten Ausgangsanschluss (Q und Qb) (406, 408); und
einem Paar entgegengesetzt orientierter Inverter (420), die zwischen den ersten und den zweiten Ausgangsanschluss (406, 408) geschaltet sind;
wobei beliebige Signale, die an dem ersten und an dem zweiten Eingangsanschluss (402, 404) anliegen, in Reaktion darauf, dass der erste (CLK) komplementäre Takteingangsanschluss eine abfallende Flanke eines Taktsignals empfängt, abgetastet werden und beliebige Signale, die an dem ersten und an dem zweiten Eingangsanschluss (402, 404) anliegen, an dem ersten und an dem zweiten Ausgangsanschluss (406, 408) in Reaktion darauf, dass der erste (CLK) komplementäre Takteingangsanschluss ein Taktsignal mit logischem Tiefpegel empfängt, stabil gehalten werden.

2. Differentieller C²MOS-Signalspeicher nach Anspruch 1, wobei der differentielle C²MOS-Signalspeicher ein Signalspeicher für positiven Pegel ist, der Signale, die an dem ersten und an dem zweiten Eingangsanschluss (402, 404) anliegen, zu dem ersten und dem zweiten Ausgangsanschluss (406, 408) in Reaktion darauf, dass der erste (CLK) komplementäre Takteingangsanschluss ein Taktsignal mit logischem Hochpegel empfängt, durchlässt.

3. Differentieller C²MOS-Signalspeicher nach einem der Ansprüche 1 bis 3, der ferner umfasst:
einen Spannungsquellen-Eingangsanschluss;
einen Masseanschluss;
einen ersten, einen zweiten, einen dritten und einen vierten Transistor, die miteinander verbunden und zwischen den Spannungsquellen-Eingangsanschluss und den Masseanschluss geschaltet sind;
wobei der erste und der vierte Transistor mit dem ersten differentiellen Ausgangsanschluss (D) verbunden sind; der zweite Transistor mit dem zweiten Takteingangsanschluss (CLKb) verbunden ist; und der dritte Transistor mit dem ersten Takteingangsanschluss (CLK) verbunden ist.

4. Differentieller C²MOS-Signalspeicher nach Anspruch 4, wobei der zweite und der dritte Transistor direkt mit dem zweiten Ausgangsanschluss (Qb) (408) verbunden sind.

5. Differentieller C²MOS-Signalspeicher nach Anspruch 5, der ferner umfasst:
einen fünften, einen sechsten, einen siebten und einen achten Transistor, die zwischen den Spannungsquellen-Eingangsanschluss und den Masseanschluss geschaltet sind.

6. Differentieller C²MOS-Signalspeicher nach Anspruch 5, wobei:
der fünfte und der achte Transistor mit dem zweiten differentiellen Ausgangsanschluss (Db) verbunden sind;
der sechste Transistor mit dem zweiten Takteingangsanschluss (CLKb) verbunden ist; und
der siebte Transistor mit dem ersten Takteingangsanschluss (CLK) verbunden ist.

7. Differentieller C²MOS-Signalspeicher nach Anspruch 6, wobei der sechste und der siebte Transistor direkt mit dem ersten Ausgangsanschluss (Q) verbunden sind.

8. Quadratur-Hilfsoszillator-Generator (Quadratur-LO-Generator) (300), der umfasst:
einen ersten und einen zweiten differentiellen C²MOS-Signalspeicher (302, 304) nach einem der Ansprüche 1 bis 7.

9. Quadratur-LO-Generator (300) nach Anspruch 8, wobei
der erste und der zweite differentielle C²MOS-Signalspeicher (302, 304) miteinander verbunden sind, um ein Paar Gleichphasen-Ausgangsanschlüsse (IP und IPb) (310, 312) und ein Paar Quadraturphasen-Ausgangsanschlüsse (QP und QPb) (306, 308) zu schaffen.

10. Quadratur-LO-Generator (300) nach Anspruch 8 oder 9, wobei der erste und der zweite C²MOS-Signalspeicher (302, 304) in einer Master-Slave-Beziehung miteinander verbunden sind.

11. Quadratur-LO-Generator nach Anspruch 9 oder 10, wobei der erste C²MOS-Signalspeicher (302) als ein positiver Signalspeicher wirkt und der zweite C²MOS-Signalspeicher (304) als ein negativer Signalspeicher wirkt.

12. Quadratur-LO-Generator nach Anspruch 8, wobei der erste Ausgangsanschluss (406) (Q) des ersten Signalspeichers (302) mit dem ersten Einganganschluss (D) (402) des zweiten C²MOS-Signalspeichers (304) verbunden ist und der zweite Ausgangsanschluss (Qb) (408) des ersten Signalspeichers (302) mit dem zweiten Eingangsanschluss (Db) (404) des zweiten Signalspeichers (304) verbunden ist; und der erste und der zweite Ausgangsanschluss (406, 408) des ersten C²MOS-Signalspeichers (302) die Gleichphasen-Ausgangsanschlüsse (IP, IPb) (310, 312) für den Quadratur-LO-Generator (300) schaffen, während der erste und der zweite Ausgangsanschluss (406, 408) des zweiten C²MOS-Signalspeichers (304) die Quadraturphasen-Ausgangsanschlüsse (QP, QPb) (306, 308) für den Quadratur-LO-Generator (300) schaffen.

## Revendications

1. Bascule différentielle CMOS avec entrée d'horloge (C²MOS) (400), comprenant :
un premier (CLK) (402) et un second (CLKb) (404) ports d'entrée d'horloge pour recevoir des signaux d'horloge complémentaires (CLOCK et CLOCKb) ;
des premier et second ports d'entrée (D et Db) (402, 404) ;
des premier et second ports de sortie (Q et Qb) (406, 408) ; et
une paire d'inverseurs dos à dos (420) couplés entre les premier et second ports de sortie (406, 408) ;
dans lequel tous les signaux présents au niveau des premier et second ports d'entrée (402, 404) sont échantillonnés en réponse à la réception par le premier port d'entrée d'horloge complémentaire (CLK) d'un signal d'horloge à front descendant et tous les signaux présents au niveau des premier et second ports d'entrée (402, 404) sont maintenus stables au niveau des premier et second ports de sortie (406, 408) en réponse à la réception par le premier port d'entrée d'horloge complémentaire (CLK) d'un signal d'horloge de niveau logique bas.

2. Bascule C²MOS différentielle selon la revendication 1, dans laquelle la bascule C²MOS différentielle est une bascule de niveau positif qui transmet les signaux présents au niveau des premier et second ports d'entrée (402, 404) aux premier et second ports de sortie (406, 408) en réponse à la réception par le premier port d'entrée d'horloge complémentaire (CLK) d'un signal d'horloge de niveau logique élevé.

3. Bascule C²MOS différentielle selon l'une quelconque des revendications 1 à 3, comprenant en outre :
un port d'entrée de source de tension ;
un port de masse ;
des premier, deuxième, troisième et quatrième transistors couplés ensemble et connectés entre le port d'entrée de source de tension et le port de masse ;
les premier et quatrième transistors étant connectés au premier port de sortie différentielle (D) ; le deuxième transistor étant connecté au second port d'entrée d'horloge (CLKb) ; et le troisième transistor étant connecté au premier port d'entrée d'horloge (CLK).

4. Bascule C²MOS différentielle selon la revendication 4, dans laquelle les deuxième et troisième transistors sont connectés directement au second port de sortie (Qb) (408).

5. Bascule C²MOS différentielle selon la revendication 5, comprenant en outre :
des cinquième, sixième, septième et huitième transistors couplés entre le port d'entrée de source de tension et le port de masse.

6. Bascule C²MOS différentielle selon la revendication 5, dans laquelle :
les cinquième et huitième transistors sont connectés au second port de sortie différentielle (Db) ;
le sixième transistor est connecté au second port d'entrée d'horloge (CLKb) ; et
le septième transistor est connecté au premier port d'entrée d'horloge (CLK).

7. Bascule C²MOS différentielle selon la revendication 6, dans laquelle les sixième et septième transistors sont connectés directement au premier port de sortie (Q).

8. Générateur d'oscillateur local (OL) en quadrature (300), comprenant :
des première et seconde bascules C²MOS différentielles (302, 304) selon l'une quelconque des revendications 1 à 7.

9. Générateur OL en quadrature (300) selon la revendication 8, dans lequel
les première et seconde bascules C²MOS différentielles (302, 304) sont couplées ensemble afin de fournir une paire de ports de sortie en phase (IP et Ipb) (310, 312) et une paire de ports de sortie en quadrature de phase (QP et QPb) (306, 308).

10. Générateur OL en quadrature (300) selon la revendication 8 ou 9, dans lequel les première et seconde bascules C²MOS (302, 304) sont couplées ensemble selon une relation maître-esclave.

11. Générateur OL en quadrature selon la revendication 9 ou 10, dans lequel la première bascule C²MOS (302) agit comme une bascule positive et la seconde bascule C²MOS (304) agit comme une bascule négative.

12. Générateur OL en quadrature selon la revendication 8, dans lequel le premier port de sortie (406) (Q) de la première bascule (302) est couplé au premier port d'entrée (D) (402) de la seconde bascule C²MOS (304) et le second port de sortie (Qb) (408) de la première bascule (302) est couplé au second port d'entrée (Db) (404) de la seconde bascule (304) ; et les premier et second ports de sortie (406, 408) de la première bascule C²MOS (302) fournissent les ports de sortie en phase (IP, Ipb) (310, 312) pour le générateur OL en quadrature (300), alors que les premier et second ports de sortie (406, 408) de la seconde bascule C²MOS (304) fournissent les ports de sortie en quadrature de phase (QP, QPb) (306, 308) pour le générateur OL en quadrature (300).
